# EUROPEAN PATENT SPECIFICATION

(11) **EP 4 473 060 B1**
(45) Date of publication and mention of the grant of the patent: **10.09.2025**
(21) Application number: 23701392.5
(22) Date of filing: 19.01.2023
(51) Int. Cl.: C08L 83/04, H01L 23/36

(54) **THERMALLY CONDUCTIVE SILICONE COMPOSITION AND METHOD FOR PRODUCING THERMALLY CONDUCTIVE MEMBER USING THE COMPOSITION**
WÄRMELEITFÄHIGE SILIKONZUSAMMENSETZUNG UND VERFAHREN ZUR HERSTELLUNG EINES WÄRMELEITFÄHIGEN ELEMENTS UNTER VERWENDUNG DER ZUSAMMENSETZUNG
COMPOSITION DE SILICONE THERMOCONDUCTRICE ET PROCÉDÉ POUR LA PRODUCTION D'UN ÉLÉMENT THERMOCONDUCTEUR À L'AIDE DE LA COMPOSITION

(30) Priority: 01.02.2022 JP 2022014200
(43) Date of publication of application: 11.12.2024
(73) Proprietor: Wacker Chemie AG, 81671 München (DE)
(72) Inventor: TAKAHASHI, Akihiro, Chikusei-shi, Ibaraki 300-4522 (JP); SAKAI, Kazuya, Chikusei-shi, Ibaraki 300-4522 (JP); YAMADA, Shunsuke, Chikusei-shi, Ibaraki 300-4522 (JP)
(74) Representative: Mieskes, Klaus Theoderich
(86) International application number: PCT/EP2023/051216
(87) International publication number: WO 2023/148005

(56) References cited:
- WO-A1-2013/051600
- WO-A1-2020/203299
- US-A1- 2007 219 312
- US-A1- 2020 270 499
- US-B2- 10 968 318

## Description

### Technical Field

The present invention relates to a curable thermally conductive silicone composition containing a thermally conductive filler and a terpene-based resin, and a method for producing a thermally conductive member using the composition.

### Background Art

As electronic components become smaller, higher in performance, and higher in output, the emitted thermal energy tends to increase, and the temperature of the electronic components tends to increase. In recent years, with the popularization of electric vehicles, high-performance batteries have been developed. In view of this background, various heat-dissipating silicone products have been developed as a thermally conductive member for transferring heat generated by a heat generating body such as electronic components and batteries to a heat dissipation member such as a heat sink.

The heat-dissipating silicone products can be roughly classified into those provided in a sheet form such as a heat dissipation sheet and those provided in a liquid form or a paste form such as a gap filler, a heat dissipation oil compound, or a heat dissipation grease.

The heat dissipation sheet is a flexible and highly thermally conductive silicone rubber sheet obtained by curing a thermally conductive silicone composition into a sheet form. Therefore, such a heat dissipation sheet can be easily installed to come into close contact with the surface of a component, thereby enhancing the heat dissipation properties. However, the heat dissipation sheet cannot properly fit a component having a complicated shape or a material exhibiting a high degree of surface roughness, and in these cases, there is an unwanted possibility that minute voids are generated at the interface thereof.

On the other hand, the gap filler is obtained by applying, in a liquid or paste form, a thermally conductive silicone composition directly to a heat generating body or a heat dissipating body, and curing the composition after the application. Therefore, the use of a gap filler is advantageous in that even when the filler is applied to a complicated irregular shape, voids will be filled and a high heat dissipation effect will be exhibited.

In order for the gap filler to exhibit a higher heat dissipation effect, it is necessary to improve the thermal conductivity of the gap filler and also improve the adhesion at the contact interface between the heat generating body or the heat dissipation body and the gap filler.

In order to obtain sufficient thermal conductivity, it is necessary for the thermally conductive silicone composition to contain a high content of a thermally conductive filler to increase the packing density of the filler when applied. However, when the thermally conductive filler is filled to achieve a high packing density, the flexibility of the gap filler after curing is impaired. As a consequence, the adhesion at the interface is lowered, the thermal resistance is increased, and thus the heat dissipation property may be impaired. Therefore, a balance between high thermal conductivity and adhesion is important.

For example, Patent Literature 1 discloses that an object of the invention is to provide a thermally conductive silicone composition and a cured product thereof which exhibit excellent thermal conductivity and water resistance and are used as a heat dissipation member having good adhesion at the time of installation, and that the object has been achieved by providing a thermally conductive silicone composition that contains an organopolysiloxane as a base polymer, aluminum nitride, and crushed alumina, wherein the content of the crushed alumina as a total amount is in the range of 60% by mass to 95% by mass. Thus, the thermal conductivity can be increased by adding a large amount of the high thermally conductive filler typified by aluminum nitride to the composition. However, this solution contains problems in that the viscosity of the composition is largely increased, the coating workability drops, the specific gravity thereof becomes large, and the cost is increased.

In order to improve adhesion, there is a method of increasing the amount of a liquid additive to be added to the thermally conductive silicone composition. However, the viscosity of the composition decreases, and there is a concern that the bead shape retentivity after pumping out or discharging is impaired.

There is also a method of improving adhesion by using an adhesive aid that chemically imparts adhesiveness, but such an adhesiveness-imparting material such as an adhesive aid usually requires some reaction energy. In this case, for example, secondary processing such as heating is required, and restrictions arise in applications.

Patent Literature 2 discloses that an elastomer contains a liquid epoxy resin to obtain an insulating layer that suppresses warpage and has excellent adhesion strength to a metal layer at a low temperature. However, it is not suitable as a heat dissipation material for an in-vehicle battery because heat curing at a high temperature is necessary.

Patent Literature 3 discloses that an electroconductive adhesive composition achieves improved adhesion by the addition of a binder resin such as an epoxy resin and a curing agent into silver powders having a predetermined particle size. Since heat curing is necessary also in this case, the composition is not suitable as the heat dissipation material for an in-vehicle battery. In addition, there are problems in that the silver powder used as a filler is costly and the electroconductive adhesive composition is not suitable for applications requiring insulating properties.

Moreover Patent Literature 4 discloses a thermally conductive silicone composition comprising a diorganopolysiloxane having an alkenyl group bonded to a silicon atom; a diorganopolysiloxane having a hydrogen atom bonded to a silicon atom; a thermally conductive filler; and an addition reaction catalyst.

### Citation List

### Patent Literature

PTL 1: Japanese Patent Application Laid-Open No. 2017-210518
PTL 2: Japanese Patent Application Laid-Open No. 2019-038969
PTL 3: WO2019/189512
PTL 4 : WO 2020/203299 A1

### Summary of Invention

### Technical Problem

In view of the above-described conventional art, an object of the present invention is to provide a thermally conductive silicone composition (serving as a gap filler, for example) which exhibits excellent coating workability on a substrate and good shape retentivity after coating, which is able to be cured to form a thermally conductive member with excellent heat dissipation properties and good adhesion to a substrate such as a heat generating body or a heat dissipation body, and which is to be applied in an uncured state to a substrate.

### Solution To Problem

The present inventors have found that the object of the present invention can be achieved by adding a terpene phenol resin into a thermally conductive silicone composition containing an organopolysiloxane, thereby completing the present invention.

Specifically, the present invention is a thermally conductive silicone composition that can contain:
a component (A) that is a diorganopolysiloxane having an alkenyl group bonded to a silicon atom;
a component (B) that is a diorganopolysiloxane having a hydrogen atom bonded to a silicon atom;
a component (C) that is a terpene phenol resin;
a component (D) that is a thermally conductive filler; and
a component (E) that is an addition reaction catalyst.

Here, the thermally conductive silicone composition is applied in an uncured state to a substrate.

### Advantageous Effects of Invention

The thermally conductive composition of the present invention exhibits excellent coating workability on a substrate and good shape retentivity after coating, and is able to be cured to form a thermally conductive member with excellent heat dissipation properties and good adhesion to a substrate such as a heat generating body or a heat dissipation body, and thus the thermally conductive composition of the present invention is suitable for use as a gap filler. Description Of Embodiments

Hereinafter, a thermally conductive silicone composition, a method for producing the thermally conductive silicone composition, and a method for improving properties of the thermally conductive silicone composition according to the present invention will be described in detail. In the description, the thermally conductive filler is also simply referred to as a filler or a filling material.

The thermally conductive silicone composition according to the present invention can contain:
a component (A) that is a diorganopolysiloxane having an alkenyl group bonded to a silicon atom;
a component (B) that is a diorganopolysiloxane having a hydrogen atom bonded to a silicon atom;
a component (C) that is a terpene phenol resin;
a component (D) that is a thermally conductive filler; and
a component (E) that is an addition reaction catalyst.

Here, the thermally conductive silicone composition is applied in an uncured state to a substrate.

The terpene phenol resin is added to the composition to increase the polarity of the composition. Thus, the adhesion of the thermally conductive member, which is obtained by curing the composition, to a substrate, particularly, to a resin substrate made of a polyethylene terephthalate (PET) or the like, can be improved while the added amounts of the component (A) and the component (B) are suppressed to be equal to or less than a predetermined amount. When the terpene phenol resin is added, the shear tensile strength of the thermally conductive member when PET is used as an adherend (between PET and PET articles) can be 0.05 MPa or more, and the shear tensile displacement can be 0.4 mm or more. This is due to the effect of the interaction between the hydroxyl group of the terpene phenol resin and the polar group of the substrate. In addition, when a liquid terpene phenol resin is used, the composition can contain the thermally conductive filler in an amount that can increase the packing density of the filler when applied and as a consequence, ensure the thermal conductivity. Furthermore, the increase in viscosity of the composition can be suppressed, and the coating workability and the shape retentivity can be maintained when the composition is applied to a substrate. The viscosity at high shear is in the range of 100 to 300 Pa·s and the viscosity at low shear is in the range of 500 to 1,200 Pa·s.

Incidentally, there are other conventionally known liquid resins that serve as a resin having certain shape retentivity and have a polar group. Examples of such resins include an acrylic resin, a polyurethane resin, and an epoxy resin. However, with these resins, there may be concerns about first, curing inhibition, and second, unfavorable storage stability due to moisture in the air. On the other hand, the terpene phenol resin is favorable in terms of storage properties when used as an additive to the silicone composition because the resin is not reactive with silicone and is stable with respect to moisture in the air.

### Component (A):

The component (A), which is the main component of the thermally conductive silicone composition, is a diorganopolysiloxane having an alkenyl group bonded to a silicon atom. The component (A) preferably has a viscosity, at 25°C, of 10 mPa·s or more and 1,000,000 mPa·s or less.

As the diorganopolysiloxane, one type thereof may be used alone, or two or more types thereof may be used in combination as appropriate. The diorganopolysiloxane is the main component of the thermally conductive silicone composition (hereinafter which may be simply referred to as a silicone composition) and has at least one alkenyl group bonded to a silicon atom within one molecule on average, preferably 2 to 50 alkenyl groups, and more preferably 2 to 20 alkenyl groups.

The component (A) does not have a specifically limited molecular structure, and may have, for example, a linear structure, a partially branched linear structure, a branched chain structure, a cyclic structure, or a branched cyclic structure. Among these, the component (A) is preferably a substantially linear organopolysiloxane, and specifically, the component (A) is preferred to be a linear diorganopolysiloxane in which the molecular chain is mainly composed of a diorganosiloxane repeat unit and of which both terminals of the molecular chain are blocked with a triorganosiloxy group. Some or all of the molecular chain terminals may be an Si-OH group.

The component (A) may be a polymer composed of a single type of siloxane unit or a copolymer composed of two or more types of siloxane units. The position of the alkenyl group bonded to the silicon atom in the component (A) is not particularly limited, and the alkenyl group may be bonded to the silicon atom at the molecular chain terminal, to the silicon atom at a non-terminal molecular chain site (in the middle of the molecular chain), or to both.

The viscosity of the component (A) at 25°C is preferably 10 mPa·s or more and 1,000,000 mPa·s or less, more preferably 20 mPa·s or more and 500,000 mPa·s or less, and still more preferably 50 mPa·s or more and 10,000 mPa·s or less. If the viscosity is too low, the filling material of the component (D), to be described later, tends to precipitate in the obtained silicone composition, and there is a concern that long-term storage stability becomes poor. In addition, if the viscosity is too high, the obtained silicone composition may tend to have remarkably low fluidity, and there may be a possibility that the coating workability tends to drop. Furthermore, if the composition is ejected with a dispenser or the like to be applied to a substrate, its fluid ejection properties may be lowered to reduce its productivity.

Two or more types of diorganopolysiloxanes having an alkenyl group and having respective different viscosities can also be used in combination to adjust the viscosity of the final product silicone composition.

Specifically, the component (A) is represented by the following general formula (1) as an average composition formula:

R¹ₐS1iO_{(4-a)/2} ... (1)

(In the formula (1), R¹s are the same as or different from each other and each are an unsubstituted or substituted monovalent hydrocarbon group of 1 to 18 carbon atoms, and a is 1.7 to 2.1.).

In one embodiment, at least two or more of the monovalent hydrocarbon groups represented by the aforementioned R¹ are selected from alkenyl groups such as a vinyl group, an allyl group, a propenyl group, an isopropenyl group, a butenyl group, an isobutenyl group, a hexenyl group, and a cyclohexenyl group. Groups other than these groups are substituted or unsubstituted monovalent hydrocarbon groups having 1 to 18 carbon atoms. Specifically, the aforementioned R¹ is selected from the group consisting of an alkyl group such as a methyl group, an ethyl group, a propyl group, an isopropyl group, a butyl group, an isobutyl group, a tert-butyl group, a pentyl group, a neopentyl group, a hexyl group, a 2-ethylhexyl group, a heptyl group, an octyl group, a nonyl group, a decyl group, and a dodecyl group; a cycloalkyl group such as a cyclopentyl group, a cyclohexyl group, and a cycloheptyl group; an aryl group such as a phenyl group, a tolyl group, a xylyl group, a biphenyl group, and a naphthyl group; an aralkyl group such as a benzyl group, a phenylethyl group, a phenylpropyl group, and a methylbenzyl group; and a halogen-substituted or cyano-substituted alkyl group in which a part or all of hydrogen atoms in the above-described hydrocarbon groups have been substituted with a halogen atom, a cyano group, or the like, such as a chloromethyl group, a 2-bromoethyl group, a 3,3,3-trifluoropropyl group, a 3-chloropropyl group, and a cyanoethyl group.

R¹s to be selected preferably include a vinyl group as the two or more alkenyl groups required, and a methyl group, a phenyl group, or a 3,3,3-trifluoropropyl group as the other groups. In addition, it is preferable that 70 mol% or more of R¹s be a methyl group, in consideration of physical properties and economic efficiency of the cured product, and normally, it is preferable that 80 mol% or more of R¹s be a methyl group.

Specific examples of the molecular structure of the component (A) include a dimethylpolysiloxane with both molecular chain terminals blocked with a dimethylvinylsiloxy group, a dimethylsiloxane-methylphenylsiloxane copolymer with both molecular chain terminals blocked with a dimethylvinylsiloxy group, a dimethylsiloxane-methylvinylsiloxane copolymer with both molecular chain terminals blocked with a dimethylvinylsiloxy group, a dimethylsiloxane-methylvinylsiloxane-methylphyenylsiloxane copolymer with both molecular chain terminals blocked with a dimethylvinylsiloxy group, a dimethylsiloxane-methylvinylsiloxane copolymer with both molecular chain terminals blocked with a trimethylsiloxy group, an organopolysiloxane composed of a siloxane unit represented by the formula: (CH₃)₂ViSiO_{1/2}, a siloxane unit represented by the formula: (CH₃)₃SiO_{1/2}, and a siloxane unit represented by the formula: SiO_{4/2} (Vi in the formula represents a vinyl group), an organopolysiloxane in which part or all of the methyl groups in the above-mentioned organopolysiloxanes are substituted by an alkyl group such as an ethyl group or a propyl group, an aryl group such as a phenyl group or a tolyl group, and a halogenated alkyl group such as a 3,3,3-trifluoropropyl group, and mixtures of two or more of these organopolysiloxanes. From the viewpoint of enhancing elongation at the time of breakage of the cured product due to increased molecular chain length, a linear diorganopolysiloxane with a vinyl group at both molecular chain terminals is preferable.

These diorganopolysiloxanes may be commercially available or prepared by methods known to those skilled in the art.

The content of the diorganopolysiloxane of the component (A), relative to 100 parts by mass of the total amount of the components (A) to (C) in the silicone composition of the present invention, is preferably 1% by mass or more and 98% by mass or less, and more preferably 10% by mass or more and 90% by mass or less.
When the content thereof falls within the aforementioned range, the viscosity of the entire silicone composition can fall within an appropriate range, and the thermally conductive silicone composition can exhibit appropriate fluidity and wettability, thereby achieving a sufficient packing density of the filler when applied. Thus, it is possible to maintain high thermal conductivity.

### Component (B):

The component (B) is a diorganopolysiloxane having a hydrogen atom bonded to a silicon atom. The component (B) preferably has a viscosity, at 25°C, of 10 mPa·s or more and 1,000,000 mPa·s or less.

The component (B) is a diorganopolysiloxane having one or more hydrogen atoms bonded to a silicon atom within one molecule, and can serve as a crosslinking agent for curing the silicone composition of the present invention.

The component (B) may be any diorganopolysiloxane as long as it contains one or more hydrogen atoms (SiH groups) bonded to a silicon atom within one molecule. Examples thereof that can be used include a dimethylsiloxane-methylhydrogensiloxane copolymer, a methylphenylsiloxane-methylhydrogensiloxane copolymer, and a copolymer composed of a dimethylhydrogensiloxy unit and an SiO_{4/2} unit. As the component (B), one type thereof may be used alone, or two or more types thereof may be used in combination as appropriate.

The molecular structure of the component (B) is not particularly limited, and may be, for example, a linear, branched, cyclic, or three-dimensional network structure. Specifically, the structure represented by the following average composition formula (2) can be used:

R³ₚH_{q}SiO_{(4-p-q)/2} (2)

(In the formula, R³ is an unsubstituted or substituted monovalent hydrocarbon group excluding an aliphatic unsaturated hydrocarbon group, p is 0 to 3.0, preferably 0.7 to 2.1, q is 0.0001 to 3.0, preferably 0.001 to 1.0, and p + q is a positive number satisfying 0.5 to 3.0, preferably 0.8 to 3.0.).

Examples of R³ in the formula (2) include non-substituted or halogen-substituted monovalent hydrocarbon groups and the like having 1 to 10 carbon atoms, preferably 1 to 8 carbon atoms excluding an aliphatic unsaturated hydrocarbon group. Specific examples thereof include an alkyl group such as a methyl group, an ethyl group, a propyl group, a butyl group, a pentyl group, a hexyl group, an isopropyl group, an isobutyl group, a tert-butyl group, and a cyclohexyl group; an aryl group such as a phenyl group, a tolyl group, and a xylyl group; an aralkyl group such as a benzyl group and a phenethyl group; and an alkyl halide group such as a 3-chloropropyl group and a 3,3,3-trifluoropropyl group. Among these, a methyl group, an ethyl group, a propyl group, a phenyl group, and a 3,3,3-trifluoropropyl group are preferable, and a methyl group is particularly preferable.

Specific examples of the component (B) include 1,1,3,3-tetramethyldisiloxane, 1,3,5,7-tetramethylcyclotetrasiloxane, a methylhydrogencyclopolysiloxane, a methylhydrogensiloxane-dimethylsiloxane cyclic copolymer, tris(dimethylhydrogensiloxy)methylsilane, tris(dimethylhydrogensiloxy)phenylsilane, a dimethylsiloxane-methylhydrogensiloxane copolymer with both molecular chain terminals blocked with a dimethylhydrogensiloxy group, a methylhydrogenpolysiloxane with both molecular chain terminals blocked with a dimethylhydrogensiloxy group, a methylhydrogenpolysiloxane with both molecular chain terminals blocked with a trimethylsiloxy group, a dimethylpolysiloxane with both molecular chain terminals blocked with a dimethylhydrogensiloxy group, a dimethylsiloxane-diphenylsiloxane copolymer with both molecular chain terminals blocked with a dimethylhydrogensiloxy group, a dimethylsiloxane-methylhydrogensiloxane copolymer with both molecular chain terminals blocked with a trimethylsiloxy group, a dimethylsiloxane-diphenylsiloxane-methylhydrogensiloxane copolymer with both molecular chain terminals blocked with a trimethylsiloxy group, a dimethylsiloxane-methylhydrogensiloxane copolymer with both molecular chain terminals blocked with a dimethylhydrogensiloxy group, a copolymer of a H(CH₃)₂SiO_{1/2} unit and an SiO₂ unit, a copolymer of a H(CH₃)₂SiO_{1/2} unit, a (CH₃)₃SiO_{1/2} unit, and an SiO₂ unit, and mixtures of two or more of these diorganopolysiloxanes.

In the silicone composition described above, the content of the component (B) is preferably in such a range that the ratio of the number of SiH groups in the component (B) to that of the alkenyl group in the component (A) falls within the range of 1/10 to 7, more preferably within the range of 1/5 to 5, and still more preferably within the range of 1/3 to 2. When the content of the component (B) falls within the aforementioned range, the silicone composition is sufficiently cured and the hardness of the entire silicone composition becomes a more preferable range, so that cracks are less likely to occur when a thermally conductive member, which is obtained by curing the composition, is used as a gap filler. In addition to these, there is an advantage that the silicone composition dose not sag and can maintain its retention ability in the vertical direction even when the substrate is disposed in a vertical orientation (erected).

The SiH group in the component (B) may be bonded to the molecular chain terminals, may be bonded to side chains, or may be bonded to both the molecular chain terminals and the side chains. It is preferable to use a mixture of a diorganopolysiloxane having an SiH group only at the molecular chain terminals and a diorganopolysiloxane having an SiH group only at the side chain of the molecular chain.

The diorganopolysiloxane having an SiH group only at the molecular chain terminals has an advantage that the diorganopolysiloxane has high reactivity due to low steric hindrance, and the diorganopolysiloxane having an SiH group at the side chains contributes to network construction by a crosslinking reaction and thus has an advantage of improving the strength of the thermally conductive member.

From the viewpoint of improving adhesion and heat resistance, the component (B) may include an organohydrogenpolysiloxane having a trimethylsiloxy group at both the molecular chain terminals and at least one aromatic group contained within the molecule. For economic reasons, the aromatic group is more preferably a phenyl group.

The viscosity of the organohydrogenpolysiloxane of the component (B) at 25°C is preferably 10 mPa·s or more and 1,000,000 mPa·s or less, more preferably 20 mPa·s or more and 500,000 mPa·s or less, and still more preferably 50 mPa·s or more and 10,000 mPa·s or less.

In order to adjust the viscosity of the silicone composition which is a final product, it is also possible to use two or more types of diorganopolysiloxanes having a hydrogen atom and having respective different viscosities.

The content of the diorganopolysiloxane of the component (B), relative to 100 parts by mass of the total amount of the components (A) to (C) in the silicone composition of the present invention, is preferably 1% by mass or more and 98% by mass or less, and more preferably 10% by mass or more and 90% by mass or less. When the viscosity falls within the aforementioned range, the viscosity of the entire silicone composition can fall within an appropriate range. Thus, the thermally conductive silicone composition has excellent crushing properties, can suppress a phenomenon in which it flows out after being applied to a substrate, and thus, it is possible to maintain high thermal conductivity due to an appropriate fluidity.

### Component (C):

The terpene phenol resin of the component (C) is a component for improving the adhesion between the thermally conductive member and the substrate, and also improving its thermal conductivity, dispensability, and shape retentivity. In order to obtain a thermally conductive member (e.g., a gap filler) having high coating workability, thermal conductivity, and shape retentivity for application to an electronic substrate or the like, a liquid terpene phenol resin is preferably used as the component (C).

Examples of the terpene-based resins include an α-pinene-based terpene resin, a β-pinene-based terpene resin, a dipentene-based terpene resin, an aromatic modified terpene resin, a terpene phenol resin having an OH group, and a hydrogenated terpene phenol resin. However, the thermally conductive silicone composition of the present invention can contain a terpene phenol resin as the component (C). This is because the OH group contained in the terpene phenol resin exhibits adhesion of the thermally conductive member to a substrate by interaction with polar atoms of the substrate (for example, carbonyl groups in a PET substrate, and OH groups of the metal surface in a metal substrate), and at the same time, the OH group interacts with the cross-linking moieties of the components (A) and (B) to suppress separation of the silicone composition after curing.

The viscosity of the component (C) at 60°C and at a shear rate of 10 (1/s) may be 30,000 mPa·s or less, and preferably 25,000 mPa·s or less.

If the viscosity at 60°C is 30,000 mPa·s or more, for example, even if the component (C) is solid, the component (C) can be mixed after being warmed. The viscosity at 60°C is preferred to be less than 30,000 mPa·s from the viewpoint of workability because the warming operation is not necessary. A viscosity of 25,000 mPa·s or less is more preferred.

The component (C) can be a terpene phenol resin in a liquid form or a viscous substance form at 23°C.

In the present invention, whether or not the terpene phenol resin is a liquid or a viscous matter can be confirmed and determined by visually checking whether or not a certain volume of a terpene phenol resin can freely flow and transform according to the shape of a container.

The hydroxyl value of the component (C) may be 10 mgKOH/g or more and 300 mgKOH/g or less, preferably 40 mgKOH/g or more and 280 mgKOH/g or less, and more preferably 200 mgKOH/g or more and 250 mgKOH/g or less.

Herein, the hydroxyl value of the component (C) is a quantity, expressed in milligrams, of potassium hydroxide required to neutralize acetic acid bound to hydroxyl groups when one gram of the component (C) is acetylated and the value is measured by potentiometric titration (in accordance with JIS K0070:1992).

When the hydroxyl value falls within the abovementioned range, the shear tensile displacement of a thermally conductive member when PET is used as an adherend (between PET and PET articles) can be made larger. The displacement is measured during the shear tensile strength test. For example, when a terpene phenol resin having a hydroxyl value of 50 mgKOH/g is added to the composition in an amount of 5 to 30 parts by mass, the shear tensile strength of the cured product (thermally conductive member) of the composition when PET is used as an adherend is 0.05 MPa or more and the shear tensile displacement thereof is 0.4 mm or more. When a terpene phenol resin having a hydroxyl value of 220 mgKOH/g is added in an amount of 5 to 30 parts by mass, the shear tensile strength of the cured product of the composition when PET is used as an adherend is 0.05 MPa or more and the shear tensile displacement thereof is 0.8 mm or more. This relationship is considered to be due to the effect of the interaction between the hydroxyl group of the terpene phenol resin and the polar group of a substrate. It is considered that the larger the hydroxyl value is, the more the number of the hydroxyl groups is and the more the number of the bonding points with the substrate is, and thus, the resulting thermally conductive member can exhibit high elongation or displacement while maintaining high shear tensile strength.

Examples of the terpene phenol resin used in the present invention include those produced by a method of polymerizing terpenes such as α-pinene, β-pinene, limonene, and terpinolene in a reaction system in which phenols are present can be used. Examples of the phenols include phenol, bisphenol A, and alkylphenols such as cresol, xylenol, p-t-butylphenol, p-octylphenol, and p-nonylphenol.

The hydroxyl value of the terpene phenol resin is generally controlled by the number of phenolic moieties. Although terpene phenols manufactured by Yasuhara Chemical Co., Ltd. are preferably used in the present invention, the hydroxyl value is preferably 10 to 300 mgKOH/g, and more preferably 50 to 230 mgKOH/g. As the terpene phenol resin, YS Polystar and YS Resin series manufactured by Yasuhara Chemical Co., Ltd. and the like are suitably used. Among these, a liquid terpene phenol resin such as YS Resin CP series and YS Polystar T-series, which do not need to be dissolved by warming, is more preferable from the viewpoint of compatibility with the liquid silicone composition.

As described above, the terpene phenol resin is preferably in a liquid state at room temperature in order to achieve compatibility with the liquid silicone composition, as well as balance between coating workability as a thermally conductive silicone composition and the high packing density using the thermally conductive filler. Specifically, The viscosity of the component (C) at 60°C may be 10 mPa·s or more and 30,000 mPa·s or less, and preferably 10 mPa·s or more and 25,000 mPa·s or less.

In the silicone composition of the present invention, the content of the component (C), relative to 100 parts by mass of the total amount of the components (A) to (C), is preferably 1 part by mass or more and 40 parts by mass or less, and more preferably 5 parts by mass or more and 30 parts by mass or less. If the content of the component (C) is too small, the shear tensile strength of the resulting thermally conductive member is 0.05 MPa or less, and adequate adhesion to a substrate cannot be achieved.
On the other hand, if the content of the component (C) is too large, the silicone composition becomes highly viscous, which may make uniform application of the silicone composition difficult.

### Component (D):

The thermally conductive filler of the component (D) improves the thermal conductivity of the silicone composition. In order to obtain a gap filler having high insulation properties for application to an electronic substrate or the like, it is preferable to use a material having excellent insulation properties as well as thermal conductivity as the thermally conductive filler of the component (D).

Examples of the thermally conductive fillers of the component (D) include a metal oxide such as aluminum oxide, zinc oxide, magnesium oxide, titanium oxide, silicon oxide, and beryllium oxide; a metal hydroxide such as aluminum hydroxide and magnesium hydroxide; a nitride such as aluminum nitride, silicon nitride, and boron nitride; a carbide such as boron carbide, titanium carbide, and silicon carbide; graphite; a metal such as aluminum, copper, nickel, and silver; and mixtures thereof. In particular, when electrical insulation properties are required for the silicone composition, the component (D) is preferably a metal oxide, a metal hydroxide, a nitride, or a mixture thereof, and it may be an amphoteric hydroxide or an amphoteric oxide. Specifically, it is preferable to use one or more types selected from the group consisting of aluminum hydroxide, boron nitride, aluminum nitride, zinc oxide, aluminum oxide, magnesium oxide, and magnesium hydroxide.

It should be noted that aluminum oxide is an insulating material, has relatively good compatibility with the components (A) and (B), can be industrially selected from a wide variety of particle diameters, is a readily available resource, is relatively inexpensive, and is therefore suitable as the thermally conductive inorganic filler.

The shape of the component (D) is not limited to a particular shape and may be spherical, amorphous, or fibrous. In particular, when aluminum oxide is used as the component (D), aluminum oxide with a spherical shape or an amorphous shape is preferably used. Spherical aluminum oxide is α-alumina obtained mainly by high temperature thermal spraying or hydrothermal treatment of alumina hydrate. Herein, the spherical shape may be not only a true spherical shape but also a rounded shape.

The amorphous shape refers to a shape where the aspect ratio of the major diameter / minor diameter of the particle is 2 or more and less than 5, and also includes what is called a scaly shape.

The spherical shape refers to a shape where the aspect ratio of the major diameter / minor diameter is 1 or more and less than 2.

The average particle diameter of the component (D) is not particularly limited, and may be in the range of, for example, 0.1 µm or more and 500 µm or less, preferably 0.5 µm or more and 200 µm or less, and more preferably 1.0 µm or more and 100 µm or less. In the present invention, the average particle diameter of the component (D) is defined by D50 (or median diameter) which is a 50% particle diameter in the volume-based cumulative particle size distribution measured by a laser diffraction particle size measuring apparatus.

In the silicone composition of the present invention, the content of the component (D), relative to 100 parts by mass of the total amount of the components (A) to (C), is preferably 300 parts by mass or more and 2,000 parts by mass or less, and more preferably 500 parts by mass or more and 1,500 parts by mass or less. When the content of the component (D) falls within the aforementioned range, the silicone composition as a whole has sufficient thermal conductivity. In addition, mixing of the component (D) can be done with ease, flexibility even after curing can be maintained, and the specific gravity thereof does not become too large. Thus, the silicone composition is more suitable as a gap filler composition for which thermal conductivity and weight reduction are required. If the content of the component (D) is too small, difficulties occur in sufficiently increasing the thermal conductivity of the resulting thermally conductive member of the silicone composition. If the content of the component (D) is too large, the silicone composition becomes highly viscous, which may make uniform application of the silicone composition difficult, resulting in problems in that thermal resistance of the thermally conductive member increases and flexibility thereof decreases.

### Component (E):

The addition reaction catalyst of the component (E) is a catalyst that promotes an addition-curing reaction between an alkenyl group bonded to a silicon atom in the component (A) described above and a hydrogen atom bonded to a silicon atom in the component (B) described above, and is a catalyst known to those skilled in the art. Examples of the component (E) include a platinum group metal such as platinum, rhodium, palladium, osmium, iridium, and ruthenium, and catalysts in which any of the aforementioned metals is supported by a particulate carrying material (for example, activated carbon, aluminum oxide, and silicon oxide).

Furthermore, examples of the component (E) include a platinum halide, a platinum-olefin complex, a platinum-alcohol complex, a platinum-alcoholate complex, a platinum-vinylsiloxane complex, dicyclopentadiene-platinum dichloride, cyclooctadiene-platinum dichloride, and cyclopentadiene-platinum dichloride.

In addition, from an economic viewpoint, a metal compound catalyst other than platinum group metals as described above may be used. Examples of the iron catalyst for hydrosilylation include an iron-carbonyl complex catalyst, an iron catalyst having a cyclopentadienyl group as a ligand, an iron catalyst having a terpyridine-based ligand or a combination of a terpyridine-based ligand and a bistrimethylsilylmethyl group, an iron catalyst having a bisiminopyridine ligand, an iron catalyst having a bisiminoquinoline ligand, an iron catalyst having an aryl group as a ligand, an iron catalyst having a cyclic or acyclic olefin group with an unsaturated group, and an iron catalyst having a cyclic or acyclic olefinyl group with an unsaturated group. Other examples of the catalyst for hydrosilylation include a cobalt catalyst, a vanadium catalyst, a ruthenium catalyst, an iridium catalyst, a samarium catalyst, a nickel catalyst, and a manganese catalyst.

The amount of the component (E) added as the concentration of the catalyst metal element is in the range of preferably 0.5 to 1,000 ppm, more preferably 1 to 500 ppm, and still more preferably 1 to 100 ppm relative to the total mass of the curable silicone composition, although an effective amount thereof depending on the curing temperature and curing time desired depending on the use application is used. If the amount added is less than 0.5 ppm, the addition reaction becomes remarkably slow. If the amount added exceeds 1,000 ppm, the cost increases, which is not economically preferable.

In the curable silicone composition containing the thermally conductive filler of the present invention, as an additional optional component other than the aforementioned components (A) to (E), a conventionally known additive for use in a silicone rubber or gel can be used as long as the object of the present invention is not impaired. Examples of such additives include an organosilicon compound or an organosiloxane (also referred to as a silane coupling agent) that produces silanols by hydrolysis, a viscosity modifier, a condensation catalyst, an adhesive imparting agent, a pigment, a dye, a curing inhibitor, a heat-resistance imparting agent, a flame retardant, an antistatic agent, a conductivity imparting agent, an airtightness improving agent, a radiation shielding agent, an electromagnetic wave shielding agent, a preservative, a stabilizer, an organic solvent, a plasticizer, a fungicide, an organopolysiloxane which contains one hydrogen atom or alkenyl group bonded to a silicon atom within one molecule and which contains no other functional groups, and a non-functional organopolysiloxane containing neither a hydrogen atom nor an alkenyl group bonded to a silicon atom. As these optional components, one type thereof may be used alone, or two or more types thereof may be used in combination as appropriate.

Examples of the silane coupling agent include an organosilicon compound and an organosiloxane having an organic group such as an epoxy group, an alkyl group, or an aryl group and a silicon atom-bonded alkoxy group within one molecule.

A silanol produced by hydrolysis can react with and bond with a condensable group (for example, a hydroxyl group, an alkoxy group, an acid group, or the like) present on the surface of a metal substrate or an organic resin substrate. The silanol and the condensable group undergo a reaction with and are bonded to each other by the catalytic effect of the condensation catalyst described later, thereby progressing the adhesion of the curable silicone composition to various substrates.

In the silicone composition of the present invention, the content of the silane coupling agent, relative to 100 parts by mass of the total amount of the components (A) to (C), is preferably 1 part by mass or more and 15 parts by mass or less, and more preferably 2 parts by mass or more and 10 parts by mass or less.

As necessary, a condensation catalyst may be used together with the silane coupling agent described above. As the condensation catalyst, a compound of a metal selected from magnesium, aluminum, titanium, chromium, iron, cobalt, nickel, copper, zinc, zirconium, tungsten, and bismuth can be used. Metal compounds such as organic acid salts, alkoxides, and chelate compounds, of trivalent aluminum, trivalent iron, trivalent cobalt, divalent zinc, tetravalent zirconium, and trivalent bismuth, are mentioned as preferable examples of the condensation catalysts. Examples thereof include an organic acid such as octylic acid, lauric acid, and stearic acid, an alkoxide such as a propoxide and a butoxide, and a multidentate ligand chelating compound such as catechol, crown ether, a polyvalent carboxylic acid, hydroxy acid, diketone, and keto acid. Here, a plurality of types of ligands may be bonded to one metal. In particular, a compound of zirconium, aluminum, or iron, which is likely to give stable curability even when the addition and use conditions are somewhat different, is preferred. In addition, examples of the more desirable compounds include a butoxide of zirconium or a trivalent chelate compound of aluminum or iron including multidentate ligands such as a malonic acid ester, an acetoacetic acid ester, an acetylacetone, or a substituted derivative thereof. In the case of a trivalent aluminum or iron metal compound, an organic acid having 5 to 20 carbon atoms, such as octylic acid, may be preferably used. The polydentate ligand and the organic acid may be bonded to one metal, and the resulting structure may also be adopted.

Examples of the aforementioned substituted derivative include those in which a hydrogen atom contained in the compound is substituted with an alkyl group such as a methyl group or an ethyl group, an alkenyl group such as a vinyl group or an allyl group, an aryl group such as a phenyl group, a halogen atom such as a chlorine atom or a fluorine atom, a hydroxyl group, a fluoroalkyl group, an ester group-containing group, an ether-containing group, a ketone-containing group, an amino group-containing group, an amide group-containing group, a carboxylic acid-containing group, a nitrile group-containing group, an epoxy group-containing group, or the like. Furthermore, specific examples thereof include 2,2,6,6-tetramethyl-3,5-heptanedione and hexafluoropentanedione.

As the viscosity modifier, an inorganic filler for imparting thixotropy such as silica and a fibrous filler, or a softener for imparting fluidity such as a polydialkylsiloxane having OH groups at both terminals may be used. In the silicone composition of the present invention, the content of the viscosity modifier, relative to 100 parts by mass of the total amount of the components (A) to (C), is preferably 0.1 parts by mass or more and 20 parts by mass or less, and more preferably 0.5 parts by mass or more and 10 parts by mass or less.

Examples of the pigment include titanium oxide, alumina silicic acid, iron oxide, zinc oxide, calcium carbonate, carbon black, a rare earth oxide, chromium oxide, a cobalt pigment, ultramarine blue, cerium silanolate, aluminum oxide, aluminum hydroxide, titanium yellow, barium sulfate, precipitated barium sulfate, and mixtures thereof.

The curing inhibitor has an ability of adjusting the curing rate of the addition reaction, and any curing inhibitor conventionally known in the art can be used as the compound having a curing suppressing effect. Examples thereof include an acetylene-based compound, hydrazines, triazoles, phosphines, and mercaptans. Specific examples of such compounds include a phosphorus-containing compound such as triphenylphosphine, a nitrogen-containing compound such as tributylamine, tetramethylethylenediamine, and benzotriazole, a sulfur-containing compound, an acetylene-based compound, a compound containing two or more alkenyl groups, a hydroperoxy compound, a maleic acid derivative, and silane and a silicone compound having an amino group.

Specific examples of the curing inhibitors include various "ene-yne" systems such as 3-methyl-3-pentene-1-yne and 3,5-dimethyl-3-hexene-1-yne; an acetylenic alcohol such as 3,5-dimethyl-1-hexin-3-ol, 1-ethynyl-1-cyclohexanol, and 2-phenyl-3-butyn-2-ol; well-known maleates and fumarates such as a dialkyl maleate, a dialkenyl maleate, a dialkoxyalkyl maleate, a dialkyl fumarate, a dialkenyl fumarate, and a dialkoxyalkyl fumarate; and those containing cyclovinylsiloxane. In particular, when the cured product is used as a gap filler, it is preferable that the curing reaction of the thermally conductive silicone composition proceed at room temperature. For this purpose, it is preferable that the component (A), i.e., a diorganopolysiloxane having an alkenyl group bonded to a silicon atom be a diorganopolysiloxane having an alkenyl group content of 1 mmol/g or less and a curing inhibitor be a diorganopolysiloxane having an alkenyl group content of 2 mmol/g or more. Examples of such a curing inhibitor include a dimethylsiloxane-methylvinylsiloxane copolymer having a vinyldimethylsiloxy group at both molecular chain terminals and having an alkenyl group content of 2 mmol/g or more.

Examples of the heat-resistance imparting agent include cerium hydroxide, cerium oxide, iron oxide, fumed titanium dioxide, and mixtures thereof.

As the airtightness improving agent, any agent may be used as long as it has an effect of reducing the air permeability of the cured product, and any organic substance or inorganic substance may be used. Specific examples thereof include a urethane, a polyvinyl alcohol, a polyisobutylene, an isobutylene-isoprene copolymer, talc having a plate-like shape, mica, glass flakes, boehmite, powders of various metal foils and metal oxides, and mixtures thereof.

The composition including the aforementioned components is a thermally conductive silicone composition that is applied in an uncured state to a substrate. That is, the composition is a liquid having an initial viscosity at 25°C and at a shear rate of 10 (1/s) in the range of 50 mPa·s or more and 2,000,000 mPa·s or less, and forms a non-flowable reactant within 120 minutes after being applied to a substrate. The preferable viscosity range is 100 mPa·s or more and 1,000,000 mPa·s or less.

The liquid silicone composition having a viscosity within the aforementioned range can be extruded from a cartridge, a ribbon, or a container such as a dispenser, a syringe or a tube, and applied to a substrate. It is preferable to apply the composition to a substrate using a dispenser with an L-shaped nozzle/needle or the like.

Here, the substrate refers to a heat dissipation portion (heat dissipation body) and a heat generating portion (heat generating body).

In the present invention, the substrate may be made of one or more materials selected from a glass, a metal, a ceramics, and a resin.

Preferable examples of metal substrates to which the thermally conductive silicone composition of the present invention adheres after curing include metal substrates of a metal selected from the group consisting of aluminum, magnesium, iron, nickel, titanium, stainless steel, copper, lead, zinc, molybdenum, silicon, and alloys of these metals.

Preferable examples of ceramic substrates to which the thermally conductive silicone composition of the present invention adheres after curing include an oxide, a carbide, and a nitride such as aluminum oxide, aluminum nitride, alumina zirconia, zirconium oxide, zinc oxide, barium titanate, lead zirconate titanate, beryllium oxide, silicon nitride, and silicon carbide.

Preferable examples of resin substrates to which the thermally conductive silicone composition of the present invention adheres after curing include resin substrates of a resin selected from the group consisting of a polyester, an epoxy, a polyamide, a polyimide, an ester, a polyacrylamide, an acrylonitrile-butadiene-styrene (ABS), a styrene, a polypropylene, a polyacetal, an acrylic resin, a polycarbonate (PC), a polyethylene terephthalate (PET), a polybutylene terephthalate (PBT), a polyetheretherketone (PEEK), a polymethylmethacrylate (PMMA), and a silicone resin.

When the thermally conductive member obtained by curing the thermally conductive silicone composition of the present invention is a gap filler for battery units, a casing for such battery units, which serves as the substrate to be an adherend, has a substrate surface with an iron surface partially coated with a cationic electrodeposition coating. When the member is a heat sink, such a heat sink may have an aluminum surface.

In the target products to which the silicone composition is applied, the heat generating portion may be disposed so as to sandwich the silicone composition after the silicone composition is applied to the heat dissipating portion, the heat dissipation portion may be disposed so as to sandwich the silicone composition after the silicone composition is applied to the heat generating portion, or the silicone composition may be injected into a gap created between the heat generating portion and the heat dissipation portion.

The aforementioned thermally conductive silicone composition has a shape retentivity of 90% or more before curing.

When the shape retentivity is 90% or more, the composition can avoid being spilled outside of the substrate surface pumping out) after being ejected onto the substrate.

Herein, the "shape retentivity" represents a change in height after 30 minutes relative to height (initial height) immediately after the thermally conductive silicone composition is applied in a circular conical shape to the substrate. As the value of the change is closer to 100%, the shape retentivity is more favorable.

In the composition described above, the component (A) and the component (B) undergo a crosslinking reaction in the presence of the addition reaction catalyst (E) to give a cured product. The composition should have a thermal conductivity of 1 or more, and may preferably be 2 or more. The specific gravity of the composition should be 1.5 or more and 10 or less. Since having reduced weight tends to be important for a member including a substrate to which the thermally conductive silicone composition is applied (e.g., an electronic device, a battery, or the like), the specific gravity of the composition is preferably 5.0 or less, and more preferably 2.9 or less.

Furthermore, the aforementioned composition preferably has certain insulation properties, and specifically, the volume resistivity thereof is preferably 10¹⁰ (Ω·cm) or higher.

The thermally conductive silicone composition can be applied to a substrate, which serves as a heat dissipation portion, and then left at room temperature to cure the composition. The shape retentivity of the thermally conductive silicone composition before curing is 90% or more. When the substrate is made of PET, the thermally conductive member obtained after curing has shear tensile strength of 0.05 MPa or more and shear tensile displacement of 0.4 mm or more at the time of separating the cured product from PET at 25°C and a shear tensile rate of 50 mm/min. The shear tensile strength is preferably 0.06 MPa or more, and more preferably 0.07 MPa or more, and is preferably 3.0 MPa or less. The displacement is preferably 0.8 mm or more, and more preferably 1.0 mm or more, and is preferably 5.0 mm or less.

When the cured product of the thermally conductive silicone composition according to the present invention has the shear tensile stress and displacement within the above-mentioned respective ranges, even if vibration is applied to a heat generating body and a heat dissipation body that are bonded to each other, the cured product is able to follow the displacement and ensure the adhesion between the heat generating body and the heat dissipation body. Thus, the thermally conductive silicone composition can serve as a suitable gap filler for enhancing heat dissipation properties of the substrate, which is the heat dissipation body, by filling a gap between the substrates and the composition.

The substrate exemplified here refers to a surface layer member of an electronic device or a battery. For example, the "substrate" refers to a substrate made of plastics such as PET, PP, PE or polyamide, a substrate made of metal such as copper, iron, aluminum or stainless steel, or a substrate obtained by subjecting any of these substrates to a surface treatment. In particular, from the viewpoint of lowering costs and weight reduction, PET may be used for the surface layer of a battery, and so adhesion of the thermally conductive member constituted by the composition of the present invention to the surface layer of PET is extremely important.

The thermally conductive silicone composition according to the present invention is an addition-curable composition and may be a one-component composition or a two-component composition. The one-component composition can have an improved storage property when the composition is appropriately designed to be cured by heat or moisture.

When the thermally conductive silicone composition is formulated as a two-component composition, the two-component composition can have a further improved storage property without the aforementioned measures, and can be easily designed to be a composition cured at a room temperature (e.g., 25°C). In that case, the silicone composition according to the present invention can be divided into a first liquid and a second liquid, for example, as follows to formulate the two-component thermally conductive silicone composition. The first liquid does not contain the component (B) but contains the component (E), and the second liquid contains the component (B) but does not contain the component (E).

For example, the first liquid contains:
the component (A) that is a diorganopolysiloxane having an alkenyl group bonded to a silicon atom, with a viscosity, at 25°C, of 10 mPa·s or more and 1,000,000 mPa·s or less;
the component (C) that is a terpene phenol resin;
the component (D) that is a thermally conductive filler; and
the component (E) that is an addition reaction catalyst, and
does not contain the component (B) that is a diorganopolysiloxane having a hydrogen atom bonded to a silicon atom, with a viscosity, at 25°C, of 10 mPa·s or more and 1,000,000 mPa·s or less.

The second liquid contains:
the component (A) that is a diorganopolysiloxane having an alkenyl group bonded to a silicon atom, with a viscosity, at 25°C, of 10 mPa·s or more and 1,000,000 mPa·s or less;
the component (B) that is a diorganopolysiloxane having a hydrogen atom bonded to a silicon atom, with at a viscosity, at 25°C, of 10 mPa·s or more and 1,000,000 mPa·s or less;
the component (C) that is a terpene phenol resin; and
the component (D) that is a thermally conductive filler; and
does not contain the component (E) that is an addition reaction catalyst.

In order to divide and store the composition as the first liquid and the second liquid, each of these components may be stored in an organic solvent such as toluene, xylene, hexane, or white spirit, or a mixture thereof. Alternatively, the different components may be emulsified using an emulsifying agent and stored as an aqueous emulsion. In particular, in order to prevent problems such as risk of fire due to volatilization of an organic solvent, deterioration of a working environment, and air pollution, it may be preferable to use a solvent-free system composition or an emulsion that is emulsified by an emulsifier.

The method for producing the thermally conductive silicone composition according to the present invention may be any method known to a person skilled in the art, and is not limited to particular one. The method may include steps of mixing the components (A), (B) and (C), then adding the component (D), and further mixing.

An exemplary method for producing the composition includes mixing the components (A), (B) and (C) in advance with a stirrer, or uniformly kneading these components with a high-shear mixer or extruder such as a two-roll mill, a kneader, a pressure kneader, a Ross mixer, a continuous extruder, or the like, to prepare a silicone rubber base, and then adding the component (D) thereto.

The component (E) and other optional components should be ultimately added in the silicone composition and may be mixed with the components (A), (B) and (C), but may also be mixed with the component (D), and may be mixed after mixing the component (D).

A thermally conductive member can be produced as follows using the two-component thermally conductive silicone composition consisting of the first and second liquids described above.

First, the first liquid and the second liquid are mixed to obtain a thermally conductive silicone composition (mixing step).

Next, the thermally conductive silicone composition obtained in the mixing step is applied to a substrate (application step).

The thermally conductive silicone composition applied in the application step cures on the substrate to form a thermally conductive member (curing step).

In the curing step, the thermally conductive silicone composition can be heated, but it is preferable to cure the composition at room temperature (for example, a temperature of 10°C or higher and 40°C or lower) .

The present invention is also a method for improving shape retentivity of a thermally conductive silicone composition, which is obtained by adding a terpene phenol resin and a thermally conductive filler to a mixture of the component (A) and the component (B), to 90% or higher after application to a substrate and also improving adhesion of a thermally conductive member (cured product), obtained by curing the thermally conductive silicone composition after application to the substrate, with respect to the substrate. The thermally conductive silicone composition of the present invention has excellent coating workability on a substrate, and the thermally conductive member obtained after curing exhibits high thermal conductivity and excellent heat dissipation properties.

### [Examples]

The present invention will be specifically described on the basis of Examples, but the present invention is not limited to the following Examples. Table 1 shows mixing ratios of components in Examples and Comparative Examples, and evaluation results. Numerical values of the mixing ratios shown in Table 1 are expressed in part by mass.

### Method for preparing thermally conductive silicone composition:

A first liquid and a second liquid described in each of Examples and Comparative Examples were weighed at a ratio of 1:1, sufficiently mixed by a stirrer, and then degassed by a vacuum pump, to produce each thermally conductive silicone composition. The curable silicone compositions were each cured at 23°C for 24 hours so as to obtain a specimen in accordance with each evaluation item. As a result, each cured product was obtained.

### Method for measuring hardness:

The first liquid and the second liquid described in each of Examples and Comparative Examples were weighed at a ratio of 1:1, sufficiently mixed by a stirrer, and then degassed by a vacuum pump. The resultant curable silicone composition was poured into a columnar press mold having a diameter of 30 mm and a height of 6 mm, and then cured at 100°C for 60 minutes, to obtain each columnar cured product.

A Shore-00 hardness was measured in accordance with the Japanese Rubber Institute Standard JIS K6253 method using a durometer hardness tester in an environment of 23°C.

Specifically, the durometer hardness tester was pressed, from directly above, against the top surface of the obtained columnar cured product, and the value obtained by bringing the pressure surface into close contact therewith was set as the measurement value. The Shore-00 hardness was measured three times using the hardness tester, and the average of the measurement results was used. In general, as the Shore-00 hardness is smaller, flexibility is higher.

It is preferable that the Shore-00 hardness of the cured product fall within the range of 40 or more and 90 or less. When the hardness is less than 40, the strength of the cured product is insufficient, and sufficient shear strength cannot be obtained. On the other hand, when the hardness exceeds 90, the flexibility of the cured product is impaired, and it is presumed that the cured product is not able to sufficiently follow the adherend's surface due to vibration after the composition was filled and cured in the gap between the heat generating body and the heat dissipation body.

### Method for measuring specific gravity:

The first liquid and the second liquid described in each of Examples and Comparative Examples were weighed at a ratio of 1:1, sufficiently mixed by a stirrer, and then degassed by a vacuum pump. The resultant curable silicone composition was poured into a sheet-shaped press mold having a height of about 10 cm, a width of about 10 cm, and a thickness of 2 mm, and then cured at 100°C for 60 minutes, to obtain each cured product.

The specific gravity (density) (g/cm³) of the cured product obtained in each of Examples and Comparative Examples was measured in accordance with JIS K6249.

In a case of application in which weight reduction is important, the specific gravity is preferably 3 or less.

### Method for measuring adhesion

A shear tensile strength was measured and regarded as adhesion. A shear tensile strength was measured in accordance with JIS K6850. Specifically, a PET plate having a length of about 60 cm, a width of about 25 cm, and a thickness of 2 mm was used as a substrate. A thermally conductive resin composition was applied to the substrate with an area of about 25 mm in length and about 25 mm in width and a thickness of about 1 mm, and the composition was sandwiched with another PET plate. The resulting article was cured at room temperature for 24 hours. A Shear tensile strength was measured in an environment of 23°C using an autograph manufactured by Shimadzu Corporation. The Shear tensile strength is preferably 0.05 MPa or more, and displacement is preferably 0.4 mm or more.

### Method for measuring thermal conductivity:

The first liquid and the second liquid described in each of Examples and Comparative Examples were weighed at a ratio of 1:1, sufficiently mixed by a stirrer, and then degassed by a vacuum pump. The resultant curable silicone composition was poured into a columnar press mold having a diameter of 30 mm and a height of 6 mm, and then cured at 100°C for 60 minutes, to obtain each columnar cured product. The thermal conductivity of the cured product was measured by a measurement device (TPS-500 manufactured by Kyoto Electronics Manufacturing Co., Ltd.) on the basis of a hot disc method in accordance with ISO 22007-2. A sensor was disposed between two columnar cured products produced as described above, and the thermal conductivity was measured by the measurement device.

The thermal conductivity is preferably 2.0 or more.

### Method for measuring mixing viscosity:

The first liquid and the second liquid described in each of Examples and Comparative Examples were weighed at a ratio of 1:1, and sufficiently mixed by a stirrer, and the viscosity of the mixture was measured at 25°C in accordance with JIS K7117-2. Specifically, the not yet cured thermally conductive composition was placed between parallel plates having a diameter of 25 mm, and the viscosity thereof was measured at a shear rate of 10 (1/s) and 1 (1/s) and a gap of 0.5 mm by Physica MR 301 manufactured by Anton Paar.

It can be said that the coating workability is good if the viscosity is 300 Pa·s or less at the shear rate of 10 (1/s). It can be said that the shape retentivity is good when the viscosity is 500 Pa·s or more at the shear rate of 1 (1/s).

### Method for evaluating shape retentivity:

The first liquid and the second liquid described in each of Examples and Comparative Examples were weighed at a ratio of 1:1, and sufficiently mixed by a stirrer. The mixture was applied in a circular cone having a bottom diameter of about 5 cm and a height of about 5 cm in an atmosphere of 23°C, and the height immediately after applying (initial height) and the height after 30 minutes were measured. When the initial height is 5 cm and the height after 30 minutes is, for example, 4 cm, the shape retentivity is 80%. A value closer to 100% is judged to be favorable shape retentivity. The shape retentivity is preferably 90% or more.

### Method for producing cured product of thermally conductive silicone composition:

### Example 1

The first liquid and the second liquid were each produced in accordance with the chemical composition shown in fields of Example 1 in Table by the following procedures. The unit of mixing ratio of each component shown in Table is part by mass.

### [First liquid for Example 1]

A diorganopolysiloxane having an alkenyl group as the component (A), a terpene phenol resin (YS resin CP, manufactured by Yasuhara Chemical Co., Ltd., with a hydroxyl value of 220 mgKOH/g) as the component (C), and a platinum-divinyl tetramethyldisiloxane complex as the component (E) were each weighed, added together, and kneaded at room temperature for 30 minutes with a planetary mixer.

A-1 as the component (A) is a linear dimethylpolysiloxane having an alkenyl group at its terminal and a viscosity of 120 mPa·s, and represented by the formula of ViMe₂SiO-(Me₂SiO)ₙ-SiMe₂Vi (Vi represents a vinyl group, Me represents a methyl group, and n is 200).

Subsequently, a half amount of n-octylethoxysilane that was a silane-coupling agent as an optional component, and as the component (D), a half amount of aluminum oxide and aluminum hydroxide being a thermally conductive filler were added thereto and kneaded at room temperature for 15 minutes with the planetary mixer.

As the aluminum oxide, spherical alumina DAM-70 manufactured by Denka Co., Ltd. (average particle diameter: 74.6 µm) was used.

As the aluminum hydroxide, BX103 manufactured by Nippon Light Metal Co., Ltd. (average particle diameter: 5 µm) was used.

After that, the remaining half amount of n-octylethoxysilane, and the remaining half amount of the spherical thermally conductive filler and the amorphous thermally conductive filler as the component (D) were added thereto and kneaded at room temperature for 15 minutes with the planetary mixer. Thus, the first liquid was produced.

### [Second liquid for Example 1]

A diorganopolysiloxane having an alkenyl group, which was the same as that in the first liquid, as the component (A), a diorganopolysiloxane having a hydrogen atom as the component (B), a terpene phenol resin, which was the same as that in the first liquid, as the component (C), and a crosslinking agent as the optional component (H) were each weighed, added together, and kneaded at room temperature for 30 minutes in a planetary mixer.

The component (B) was a linear dimethylhydrogenpolysiloxane having an SiH group both at a side chain and its terminal, with a viscosity of 20 mPa·s.

The crosslinking agent was a dimethylpolysiloxane having a hydrogen atom bonded to a silicon atom only at a side chain, with a viscosity of 200 mPa·s.

Subsequently, a half amount of n-octylethoxysilane that was a silane-coupling agent as an optional component, and as the component (D), a half amount of aluminum oxide and aluminum hydroxide being a thermally conductive filler were added thereto and kneaded at room temperature for 15 minutes with the planetary mixer. After that, the remaining half amount of n-octylethoxysilane, and the remaining half amount of the spherical thermally conductive filler and the amorphous thermally conductive filler as the component (D) were added thereto and kneaded at room temperature for 15 minutes with the planetary mixer. Thus, the second liquid for Example 1 was produced.

### (Examples 2 to 5)

A first liquid and a second liquid were prepared by the same method as that in Example 1 except that the added amounts of the component (A) and the terpene phenol resin in the first liquid, and the added amounts of the component (B) and the terpene phenol resin in the second liquid were changed.

### (Examples 6 to 8)

A first liquid and a second liquid were prepared by the same method as that in Example 3 except that the added amount of the filler was changed.

### (Example 9)

A first liquid and a second liquid were prepared by the same method as that in Example 3 except that the terpene phenol resin used was changed to a YS Polystar T30 (manufactured by Yasuhara Chemical Co., Ltd., with a hydroxyl value of 50 to 60 mgKOH/g).

### (Comparative Example 1)

A first liquid and a second liquid were prepared by the same method as that in Example 1 except that the terpene phenol resin was not added.

### (Comparative Examples 2 to 3)

A first liquid and a second liquid were prepared by the same method as that in Comparative Example 1 except that a silicone polymer having a high viscosity was added.

"A-2" used as the component (A) in Comparative Example 2 is a linear dimethylpolysiloxane having an alkenyl group at the terminal and a viscosity of 11,000 mPa·s, and is a dimethylorganopolysiloxane having at least one hydroxyl group within the molecule.

"A-3" used as the component (A) in Comparative Example 3 is a linear dimethylpolysiloxane having an alkenyl group at the terminal and a viscosity of 1,000 mPa·s.

### (Comparative Examples 4 to 5)

In Comparative Example 4, a first liquid and a second liquid were prepared by the same method as that in Example 3 except that Dimeron (manufactured by Yasuhara Chemical Co., Ltd.), which is a terpene resin, was added instead of the terpene phenol resin.

In Comparative Example 5, a first liquid and a second liquid were prepared by the same method as that in Example 3 except that a YS resin LP (manufactured by Yasuhara Chemical Co., Ltd.), which is a terpene resin, was added instead of the terpene phenol resin.

### The evaluation results are shown in Table 1.

In Examples 1 to 9, the shear tensile strength between PET substrates was 0.05 MPa or more, and the shear tensile displacement was 1.0 mm or more. The adhesion to the PET substrate was good and the viscosity of the composition in the shear rate of 10/s was as low as 300 Pa·s or less. Thus, the ejection properties were good, and the shape retentivity was as very good as 95%.

In Examples 1 to 5, the added amount of the terpene phenol resin was varied in the range of 5 to 40 parts by mass, and good results were obtained in all examples in terms of the shear tensile strength, the shear tensile displacement, the viscosity, and the shape retentivity.

In Examples 6 to 8, the added amounts of the filler were changed from that in Example 3, but the results were good in terms of all the shear tensile strength, the shear tensile displacement, the viscosity, and the shape retentivity.

In Example 9, a terpene phenol resin having a low hydroxyl value was used instead of the terpene phenol resin used in Example 3. In this case, although the shear tensile displacement decreased, the shear tensile strength, viscosity, and shape retentivity were all good.

Although Comparative Examples 1 to 3 were compositions not containing a terpene-based resin, the shape retentivity was good. However, the Shore-00 hardness was 90 or more, and it is presumed that the followability of the cured product to the substrates in the gap between the heat generating body and the heat dissipation body against vibration was insufficient. In Comparative Example 1, the shear tensile strength was low and the adhesion to the adherend was insufficient. In Comparative Examples 2 to 3, a silicone polymer having a higher viscosity was added for the purpose of increasing the viscosity in the low shear rate region, and so the adhesion was good. However, the viscosity at the high shear rate had also been unfavorably increased, and it cannot be said that the ejection properties were good.

In Comparative Examples 4 to 5, the terpene resin having no phenol group was added, but the shear tensile strength for evaluating adhesion to PET substrate was low, and it cannot be said that the adhesion was sufficiently high. Furthermore, the viscosity at a low shear rate was 500 Pa·s or less, and it cannot be said that the shape retentivity after ejection was sufficient.

**[Table 1]**

| First liquid | | | Comparative Example 1 | Comparative Example 2 | Comparative Example 3 | Comparative Example 4 | Comparative Example 5 | Example 1 | Example 2 | Example 3 | Example 4 | Example 5 | Example 6 | Example 7 | Example 8 | Example 9 |
|---|---|---|---|---|---|---|---|---|---|---|---|---|---|---|---|---|
| Si-Vi polymer | A-1 | | 100 | 90 | 90 | 90 | 90 | 60 | 70 | 80 | 90 | 95 | 90 | 90 | 90 | 90 |
| Si-Vi polymer | A-2 | | | 10 | | | | | | | | | | | | |
| Si-Vi polymer | A-3 | | | | 10 | | | | | | | | | | | |
| Dimeron | C-1 | | | | | 10 | | | | | | | | | | |
| YS Resin LP | C-2 | | | | | | 10 | | | | | | | | | |
| YS Resin CP | C-3 | | | | | | | 40 | 30 | 20 | 10 | 5 | 10 | 10 | 10 | |
| YS Polystar T30 | C-4 | | | | | | | | | | | | | | | 10 |
| Aluminum Oxide | D-1 | | 250 | 250 | 250 | 250 | 250 | 250 | 250 | 250 | 250 | 250 | 640 | 890 | | 250 |
| Aluminum Hydroxide | D-2 | | 640 | 640 | 640 | 640 | 640 | 640 | 640 | 640 | 640 | 640 | 250 | | 890 | 640 |
| Pt-Cat. | E | | 2 | 2 | 2 | 2 | 2 | 2 | 2 | 2 | 2 | 2 | 2 | 2 | 2 | 2 |
| Silane-coupling Agent | | | 5 | 5 | 5 | 5 | 5 | 5 | 5 | 5 | 5 | 5 | 5 | 5 | 5 | 5 |
| Color Pigment | | | 3 | 3 | 3 | 3 | 3 | 3 | 3 | 3 | 3 | 3 | 3 | 3 | 3 | 3 |
| Second Liquid | | | | | | | | | | | | | | | | |
| Si-Vi polymer | A-1 | | 50 | 40 | 40 | 40 | 40 | 20 | 10 | 30 | 40 | 45 | 40 | 40 | 40 | 40 |
| Si-Vi polymer | A-2 | | | 10 | | | | | | | | | | | | |
| Si-Vi polymer | A-3 | | | | 10 | | | | | | | | | | | |
| Si-H polymer | B | | 50 | 50 | 50 | 50 | 50 | 40 | 50 | 50 | 50 | 50 | 50 | 50 | 50 | 50 |
| Dimeron | C-1 | | | | | 10 | | | | | | | | | | |
| YS Resin LP | C-2 | | | | | | 10 | | | | | | | | | |
| YS Resin CP | C-3 | | | | | | | 40 | 30 | 20 | 10 | 5 | 10 | 10 | 10 | |
| YS Polystar T30 | C-4 | | | | | | | | | | | | | | | 10 |
| Aluminum Oxide | D-1 | | 250 | 250 | 250 | 250 | 250 | 250 | 250 | 250 | 250 | 250 | 640 | 890 | | 250 |
| Aluminum Hydroxide | D-2 | | 640 | 640 | 640 | 640 | 640 | 640 | 640 | 640 | 640 | 640 | 250 | | 890 | 640 |
| Cross-linking Agent | | | 1 | 1 | 1 | 1 | 1 | 1 | 1 | 1 | 1 | 1 | 1 | 1 | 1 | 1 |
| Silane-coupling Agent | | | 5 | 5 | 5 | 5 | 5 | 5 | 5 | 5 | 5 | 5 | 5 | 5 | 5 | 5 |

| | | | Comparative Example 1 | Comparative Example 2 | Comparative Example 3 | Comparative Example 4 | Comparative Example 5 | Example 1 | Example 2 | Example 3 | Example 4 | Example 5 | Example 6 | Example 7 | Example 8 | Example 9 |
|---|---|---|---|---|---|---|---|---|---|---|---|---|---|---|---|---|
| Viscosity @ 25°C | 1/s | [Pa·s] | 554 | 985 | 1020 | 363 | 392 | 654 | 602 | 560 | 536 | 555 | 532 | 500 | 589 | 544 |
| | 10/s | [Pa·s] | 158 | 312 | 308 | 132 | 142 | 245 | 223 | 200 | 183 | 160 | 167 | 150 | 204 | 173 |
| Shear Tensile between PET-PET | Stress | [MPs] | 0.06 | 0.41 | 0.40 | 0.01 | 0.02 | 0.06 | 0.07 | 0.07 | 0.07 | 0.05 | 0.06 | 0.07 | 0.06 | 0.06 |
| | Displacement | [mm] | 0.33 | 0.85 | 0.83 | 0.53 | 0.39 | 1.45 | 1.35 | 1.30 | 1.26 | 1.20 | 1.22 | 1.32 | 0.87 | 0.46 |
| Thermal Conductivity | | [W/mxk] | 3.0 | 3.0 | 3.0 | 3.0 | 3.0 | 3.0 | 3.0 | 3.0 | 3.0 | 3.0 | 3.1 | 3.2 | 2.9 | 3.0 |
| Hardness | Shore 00 | [-] | 90 | 93 | 90 | 71 | 77 | 50 | 60 | 68 | 72 | 82 | 68 | 65 | 75 | 78 |
| Specific Gravity | | [-] | 2.24 | 2.22 | 2.22 | 2.22 | 2.22 | 2.22 | 2.22 | 2.22 | 2.22 | 2.22 | 2.25 | 2.28 | 2.17 | 2.22 |
| Shape Retentivity | | [mm] | 100% | 100% | 100% | 80% | 80% | 100% | 100% | 100% | 100% | 100% | 100% | 100% | 100% | 100% |

## Claims

1. A thermally conductive silicone composition comprising:
a component (A) that is a diorganopolysiloxane having an alkenyl group bonded to a silicon atom;
a component (B) that is a diorganopolysiloxane having a hydrogen atom bonded to a silicon atom;
a component (C) that is a terpene phenol resin;
a component (D) that is a thermally conductive filler; and
a component (E) that is an addition reaction catalyst, wherein
the thermally conductive silicone composition is applied in an uncured state to a substrate.

2. The thermally conductive silicone composition according to claim 1, wherein the component (C) has a viscosity, at 60°C, of 30,000 mPa·s or less.

3. The thermally conductive silicone composition according to claim 1 or 2, wherein the component (C) is a terpene phenol resin in a liquid form or a viscous substance form at 23°C.

4. The thermally conductive silicone composition according to any one of claims 1 to 3, wherein a content of the component (C), relative to 100 parts by mass of a total amount of the component (A), the component (B), and the component (C), is 1 part by mass or more and 40 parts by mass or less.

5. The thermally conductive silicone composition according to any one of claims 1 to 4, wherein the thermally conductive filler of the component (D) contains at least one selected from the group consisting of aluminum hydroxide and aluminum oxide.

6. The thermally conductive silicone composition according to any one of claims 1 to 4, wherein, relative to 100 parts by mass of a total amount of the component (A), the component (B), and the component (C),
the component (A) is contained in an amount of 1 to 98 parts by mass,
the component (B) is contained in an amount of 1 to 98 parts by mass,
the component (C) is contained in an amount of 1 to 40 parts by mass,
the component (D) is contained in an amount of 300 to 2000 parts by mass, and
the component (E) is contained in a catalytic amount.

7. The thermally conductive silicone composition according to any one of claims 1 to 6, wherein:
a cured product of the thermally conductive silicone composition after curing has shear tensile strength of 0.05 MPa or more and shear tensile displacement of 0.4 mm or more at a time when the cured product is separated from a PET substrate at 25°C and a shear tensile rate of 50 mm/min; and
the thermally conductive silicone composition before curing has a shape retentivity of 90% or more measured as disclosed in the specification.

8. A method for producing a thermally conductive member, comprising:
a mixing step of mixing a first liquid and a second liquid to obtain a thermally conductive silicone composition;
an applying step of applying the thermally conductive silicone composition to a substrate; and
a curing step of curing the thermally conductive silicone composition applied in the applying step, wherein
the first liquid contains
a component (A) that is a diorganopolysiloxane having an alkenyl group bonded to a silicon atom,
a component (C) that is a terpene phenol resin,
a component (D) that is a thermally conductive filler, and
a component (E) that is an addition reaction catalyst,
the first liquid does not contain a component (B) that is a diorganopolysiloxane having a hydrogen atom bonded to a silicon atom,
the second liquid contains
the component (A) that is a diorganopolysiloxane having an alkenyl group bonded to a silicon atom,
the component (B) that is a diorganopolysiloxane having a hydrogen atom bonded to a silicon atom,
the component (C) that is a terpene phenol resin, and
the component (D) that is a thermally conductive filler, and
the second liquid does not contain the component (E) that is an addition reaction catalyst.

9. A method for improving adhesion of a cured product of a thermally conductive silicone composition to a substrate and maintaining a shape retentivity of 90% or more of the thermally conductive silicone composition measured as disclosed in the specification, the method comprising
adding a component (C) that is a terpene phenol resin to a thermally conductive silicone composition containing
a component (A) that is a diorganopolysiloxane having an alkenyl group bonded to a silicon atom,
a component (B) that is a diorganopolysiloxane having a hydrogen atom bonded to a silicon atom
a component (D) that is a thermally conductive filler, and
a component (E) that is an addition reaction catalyst.

## Patentansprüche

1. Wärmeleitfähige Siliconzusammensetzung umfassend:
eine Komponente (A), die ein Diorganopolysiloxan mit einer an ein Siliciumatom gebundenen Alkenylgruppe ist;
eine Komponente (B), die ein Diorganopolysiloxan mit einem an ein Siliciumatom gebundenen Wasserstoffatom ist;
eine Komponente (C), die ein Terpenphenolharz ist;
eine Komponente (D), die ein wärmeleitfähiger Füllstoff ist; und
eine Komponente (E), die ein Additionsreaktionskatalysator ist, wobei die wärmeleitfähige Siliconzusammensetzung in einem ungehärteten Zustand auf ein Substrat aufgebracht wird.

2. Wärmeleitfähige Siliconzusammensetzung nach Anspruch 1, wobei die Komponente (C) eine Viskosität bei 60 °C von 30.000 MPa·s oder weniger aufweist.

3. Wärmeleitfähige Siliconzusammensetzung nach Anspruch 1 oder 2, wobei die Komponente (C) ein Terpenphenolharz in einer flüssigen Form oder der Form eines viskosen Stoffs bei 23 °C ist

4. Wärmeleitfähige Siliconzusammensetzung nach einem der Ansprüche 1 bis 3, wobei ein Gehalt an der Komponente (C), bezogen auf 100 Masseteile der Gesamtmenge von Komponente (A), Komponente (B) und Komponente (C), 1 Masseteil oder mehr und 40 Masseteile oder weniger beträgt.

5. Wärmeleitfähige Siliconzusammensetzung nach einem der Ansprüche 1 bis 4, wobei der wärmeleitfähige Füllstoff der Komponente (D) wenigstens einen ausgewählt aus der Gruppe bestehend aus Aluminiumhydroxid und Aluminiumoxid enthält.

6. Wärmeleitfähige Siliconzusammensetzung nach einem der Ansprüche 1 bis 4**,** wobei, bezogen auf 100 Masseteile der Gesamtmenge von Komponente (A), Komponente (B) und Komponente (C),
die Komponente (A) in einer Menge von 1 bis 98 Masseteile enthalten ist,
die Komponente (B) in einer Menge von 1 bis 98 Masseteile enthalten ist,
die Komponente (C) in einer Menge von 1 bis 40 Masseteile enthalten ist,
die Komponente (D) in einer Menge von 300 bis 2000 Masseteile enthalten ist und
die Komponente (E) in einer katalytischen Menge enthalten ist.

7. Wärmeleitfähige Siliconzusammensetzung nach einem der Ansprüche 1 bis 6, wobei:
ein gehärtetes Produkt der wärmeleitfähigen Siliconzusammensetzung nach Härten eine Scherzugfestigkeit von 0,05 MPa oder mehr und eine Scherzugverschiebung von 0,4 mm oder mehr zu einem Zeitpunkt aufweist, bei dem das gehärtete Produkt bei 25 °C und mit einer Scherzuggeschwindigkeit von 50 mm/min von einem PET-Substrat getrennt wird; und
die wärmeleitfähige Siliconzusammensetzung vor Härten eine Formbeständigkeit von 90 % oder mehr, gemessen wie in der Beschreibung offenbart, aufweist.

8. Verfahren zur Herstellung eines wärmeleitfähigen Elements, umfassend:
einen Mischschritt des Mischens einer ersten Flüssigkeit und einer zweiten Flüssigkeit, um eine wärmeleitfähige Siliconzusammensetzung zu erhalten;
einen Aufbringschritt des Aufbringens der wärmeleitfähigen Siliconzusammensetzung auf ein Substrat; und
einen Härtungsschritt des Härtens der bei dem Aufbringschritt aufgebrachten wärmeleitfähigen Siliconzusammensetzung, wobei
die erste Flüssigkeit enthält
eine Komponente (A), die ein Diorganopolysiloxan mit einer an ein Siliciumatom gebundenen Alkenylgruppe ist,
eine Komponente (C), die ein Terpenphenolharz ist,
eine Komponente (D), die ein wärmeleitfähiger Füllstoff ist; und
eine Komponente (E), die ein Additionsreaktionskatalysator ist,
wobei die erste Flüssigkeit keine Komponente (B) enthält, die ein Diorganopolysiloxan mit einem an ein Siliciumatom gebundenen Wasserstoffatom ist,
die zweite Flüssigkeit enthält
die Komponente (A), die ein Diorganopolysiloxan mit einer an ein Siliciumatom gebundenenen Alkenylgruppe ist,
die Komponente (B), die ein Diorganopolysiloxan mit einem an ein Siliciumatom gebundenen Wasserstoffatom ist,
die Komponente (C), die ein Terpenphenolharz ist, und
die Komponente (D), die ein wärmeleitfähiger Füllstoff ist, und
die zweite Flüssigkeit die Komponente (E), die ein Additionsreaktionskatalysator ist, nicht enthält.

9. Verfahren zum Verbessern der Haftung eines gehärteten Produkts einer wärmeleitfähigen Siliconzusammensetzung an einem Substrat und Bewahren einer Formbeständigkeit von 90 % oder mehr der wärmeleitfähigen Siliconzusammensetzung, gemessen wie in der Beschreibung offenbart, wobei das Verfahren umfasst Zugeben einer Komponente (C), die ein Terpenphenolharz ist, zu einer wärmeleitfähigen Siliconzusammensetzung, die enthält
eine Komponente (A), die ein Diorganopolysiloxan mit einer an ein Siliciumatom gebundenen Alkenylgruppe ist, eine Komponente (B), die ein Diorganopolysiloxan mit einem an ein Siliciumatom gebundenen Wasserstoffatom ist, eine Komponente (D), die ein wärmeleitfähiger Füllstoff ist; und
eine Komponente (E), die ein Additionsreaktionskatalysator ist.

## Revendications

1. Composition de silicone thermiquement conductrice comprenant :
un composant (A) qui est un diorganopolysiloxane ayant un groupe alcényle lié à un atome de silicium ;
un composant (B) qui est un diorganopolysiloxane ayant un atome d'hydrogène lié à un atome de silicium ;
un composant (C) qui est une résine de terpènephénol ;
un composant (D) qui est une charge thermiquement conductrice ; et
un composant (E) qui est un catalyseur de réaction d'addition, dans laquelle
la composition de silicone thermiquement conductrice est appliquée dans un état non durci sur un substrat.

2. Composition de silicone thermiquement conductrice selon la revendication 1, dans laquelle le composant (C) a une viscosité, à 60 °C, de 30 000 mPa·s ou moins.

3. Composition de silicone thermiquement conductrice selon la revendication 1 ou 2, dans laquelle le composant (C) est une résine de terpènephénol sous une forme liquide ou une forme de substance visqueuse à 23 °C.

4. Composition de silicone thermiquement conductrice selon l'une quelconque des revendications 1 à 3, dans laquelle une teneur du composant (C), par rapport à 100 parties en masse d'une quantité totale du composant (A), du composant (B) et du composant (C), est de 1 partie en masse ou plus et de 40 parties en masse ou moins.

5. Composition de silicone thermiquement conductrice selon l'une quelconque des revendications 1 à 4, dans laquelle la charge thermiquement conductrice du composant (D) contient au moins l'un choisi dans le groupe constitué par l'hydroxyde d'aluminium et l'oxyde d'aluminium.

6. Composition de silicone thermiquement conductrice selon l'une quelconque des revendications 1 à 4, dans laquelle, par rapport à 100 parties en masse d'une quantité totale du composant (A), du composant (B) et du composant (C),
le composant (A) est contenu en une quantité de 1 à 98 parties en masse,
le composant (B) est contenu en une quantité de 1 à 98 parties en masse,
le composant (C) est contenu en une quantité de 1 à 40 parties en masse,
le composant (D) est contenu en une quantité de 300 à 2 000 parties en masse, et
le composant (E) est contenu en une quantité catalytique.

7. Composition de silicone thermiquement conductrice selon l'une quelconque des revendications 1 à 6, dans laquelle :
un produit durci de la composition de silicone thermiquement conductrice après durcissement a une résistance à la traction en cisaillement de 0,05 MPa ou
plus et un déplacement à la traction en cisaillement de 0,4 mm ou plus à un moment où le produit durci est séparé d'un substrat de PET à 25 °C et une vitesse de traction en cisaillement de 50 mm/min ; et
la composition de silicone thermiquement conductrice avant durcissement présente une rémanence de forme de 90 % ou plus mesurée comme divulgué dans la description.

8. Procédé pour la production d'un élément thermiquement conducteur, comprenant :
une étape de mélange consistant à mélanger un premier liquide et un second liquide pour obtenir une composition de silicone thermiquement conductrice ;
une étape d'application consistant à appliquer la composition de silicone thermiquement conductrice sur un substrat ; et
une étape de durcissement consistant à durcir la composition de silicone thermiquement conductrice appliquée dans l'étape d'application, dans lequel le premier liquide contient
un composant (A) qui est un diorganopolysiloxane ayant un groupe alcényle lié à un atome de silicium,
un composant (C) qui est une résine de terpènephénol,
un composant (D) qui est une charge thermiquement conductrice, et
un composant (E) qui est un catalyseur de réaction d'addition,
le premier liquide ne contient pas de composant (B) qui est un diorganopolysiloxane ayant un atome d'hydrogène lié à un atome de silicium,
le second liquide contient
le composant (A) qui est un diorganopolysiloxane ayant un groupe alcényle lié à un atome de silicium,
le composant (B) qui est un diorganopolysiloxane ayant un atome d'hydrogène lié à un atome de silicium,
le composant (C) qui est une résine de terpènephénol, et
le composant (D) qui est une charge thermiquement conductrice, et
le second liquide ne contient pas le composant (E) qui est un catalyseur de réaction d'addition.

9. Procédé pour améliorer l'adhérence d'un produit durci d'une composition de silicone thermiquement conductrice à un substrat et maintenir une rémanence de forme de 90 % ou plus de la composition de silicone thermiquement conductrice mesurée comme divulgué dans la description, le procédé comprenant
l'addition d'un composant (C) qui est une résine de terpènephénol à une composition de silicone thermiquement conductrice contenant
un composant (A) qui est un diorganopolysiloxane ayant un groupe alcényle lié à un atome de silicium,
un composant (B) qui est un diorganopolysiloxane ayant un atome d'hydrogène lié à un atome de silicium un composant (D) qui est une charge thermiquement conductrice, et
un composant (E) qui est un catalyseur de réaction d'addition.
